# EUROPEAN PATENT SPECIFICATION

(11) **EP 3 227 977 B1**
(45) Date of publication and mention of the grant of the patent: **02.06.2021**
(21) Application number: 14830549.3
(22) Date of filing: 03.12.2014
(51) Int. Cl.: H01S 5/22, H01S 5/227, H01S 5/34

(54) **QUANTUM CASCADE LASER WITH CURRENT BLOCKING LAYERS**
QUANTENKASKADENLASER MIT STROMSPERRSCHICHTEN
LASER À CASCADE QUANTIQUE À COUCHES DE BLOCAGE DU COURANT

(43) Date of publication of application: 11.10.2017
(73) Proprietor: Alpes Lasers S.A., 2072 St-Blaise (CH)
(72) Inventor: BISMUTO, Alfredo, CH-2000 Neuchatel (CH); FAIST, Jérôme, CH-8052 Zürich (CH); GINI, Emilio, CH-8102 Oberengstringen (CH); HINKOV, Borislav, AT-1030 Wien (AT)
(74) Representative: Klocke, Peter
(86) International application number: PCT/IB2014/002666
(87) International publication number: WO 2016/087888

(56) References cited:
- US-A1- 2003 086 462
- US-A1- 2003 173 571
- US-A1- 2013 329 761
- GUO DINGKAI ET AL: "Electrical derivative measurement of quantum cascade lasers", JOURNAL OF APPLIED PHYSICS, AMERICAN INSTITUTE OF PHYSICS, US, vol. 109, no. 4, 22 February 2011 (2011-02-22), pages 43105-43105, XP012147530, ISSN: 0021-8979, DOI: 10.1063/1.3549731
- TSANG W T ET AL: "A NEW LATERAL SELECTIVE-AREA GROWTH BY LIQUID-PHASE EPITAXY: THE FORMATION OF A LATERAL DOUBLE-BARRIER BURIED-HETEROSTRUCTURE LASER", APPLIED PHYSICS LETTERS, AMERICAN INSTITUTE OF PHYSICS, vol. 40, no. 11, 1 June 1982 (1982-06-01), pages 942-944, XP000706426, ISSN: 0003-6951, DOI: 10.1063/1.92960

## Description

### BACKGROUND AND PRIOR ART

The present invention relates to semiconductor lasers, in particular to Quantum Cascade Lasers (QCLs) emitting in the IR spectral range, i.e. at wavelengths of 1mm to 780nm, especially in the mid IR range of 3-50µm.

The mid-IR spectral range is important for sensing applications due to the large number of molecules showing fundamental resonances in this region. Quantum Cascade Lasers (QCLs) have become frequently used and efficient laser sources for such applications. Examples are Maulini US patent 7 944 959 and Faist US patent application 2003/0 174 751. A QCL laser generating a mid-IR spectrum is also shown in Vurgaftman US patent 8 290 011.

Typical lateral-guiding structures used to form waveguides for quantum cascade lasers (QCLs) are deep-etched ridge waveguides, shallow-etched ridge waveguides or deep buried heterostructure (BH) waveguides. For high power and high performance devices, the buried heterostructure configuration is favored since it presents a higher thermal conductivity of the InP burying layers and at the same time guarantees low losses. Beck US patent 6 665 325 is an example.

More specifically, the current blocking in the case of the Fe-doped InP is guaranteed by the built-in potential present at the interface between the Fe-doped InP and the n-doped InP contact layer. Since Fe acts as a deep donor level in InP, it also actively helps to trap electrons and thus prevents leakage currents. The magnitude of the built-in potential can be controlled by adjusting the Fe-doping in the InP. Unfortunately the latter parameter is strongly connected to the growth parameters and the built-in potential is typically limited to 50-100 kV/cm. Typically in the case of QCLs operating in a high electric field, the current is therefore partially driven inside the insulating burying layers. This effect reduces the actual current injected into the laser active region and, at the same time, it dissipates heat and therefore degrades laser performance.

In addition, it is well known that the introduction of Fe impurities inside the burying layers creates defect states inside the semiconductor forbidden gap, see P.B. Klein et al., Phys. Rev. B 29, 1947 (1984): Time-dependent photoluminescence of InP:Fe. This levels present absorptions, especially in the 3-4 µm spectral range, preventing the production of buried-heterostructure laser devices in this range.

This spectral region however is of crucial interest for spectroscopy and sensing applications due to the presence of fundamental resonances of many molecules in this spectral region. One of the aims of the present invention is to overcome the above-mentioned limitation and devise a method for making BH lasers with low optical losses also in this spectral range.

However, it should be understood that the present invention is not limited to QCLs of this wavelength, but is generally applicable for QCLs across the spectral range, e.g. to any BH laser design, be it a QCL with multi-color emitters or any other BH laser.

### BRIEF SUMMARY OF THE INVENTION

In principle, the present invention discloses a novel structure of deep etched buried heterostructure quantum cascade lasers, i.e. BH QCLs, by including specific quantum barriers into a structure of multiple different, potentially doped semiconductor layers as burying layers. Useful barrier materials include AlAs and InAIAs, InGaAs, InGaAsP, and InGaSb.

By introducing specific quantum barriers and modifying number, thickness, and/or doping of the various layers constituting the burying layers, the conductivity of the burying layer(s) can be adjusted; it can be reduced especially in the case of high applied fields.

The concept of the present invention is applicable to undoped/intrinsic InP as well as to Fe-doped InP as main structural component of the burying layer. Advantageously, the absence of Fe impurities in the burying layers allows the fabrication of high performance BH lasers even in the 3-4µm spectral region without penalizing laser performance by introducting additional losses.

GUO DINGKAI ET AL, "Electrical derivative measurement of quantum cascade lasers", JOURNAL OF APPLIED PHYSICS, AMERICAN INSTITUTE OF PHYSICS, vol. 109, no. 4, 22 February 2011, presents a study of current blocking structures in ridge QCLs and more specifically discloses the use of a stacked hetero-junctions multilayer to provide for the current confinement.

Details and further advantages of the invention will be shown in the following description of several examples which are illustrated in the appended drawings.

### BRIEF DESCRIPTION OF THE DRAWINGS

The appended drawings show in:
- Fig. 1a: a prior art buried heterostructure design,
- Fig. 1b: the schematic band structure for the prior art design of Fig. 1a
- Fig. 2a: a first embodiment according to the invention,
- Fig. 2b: the schematic band structure for the embodiment of Fig. 2a,
- Fig. 3a: a second embodiment according to the invention,
- Fig. 3b: the schematic band structure for the embodiment of Fig. 3a,
- Fig. 4: the schematic band structure of a third embodiment.

### DETAILED DESCRIPTION OF SEVERAL EMBODIMENTS

The following description refers to the appended figures showing the prior art and some embodiments of the present invention.

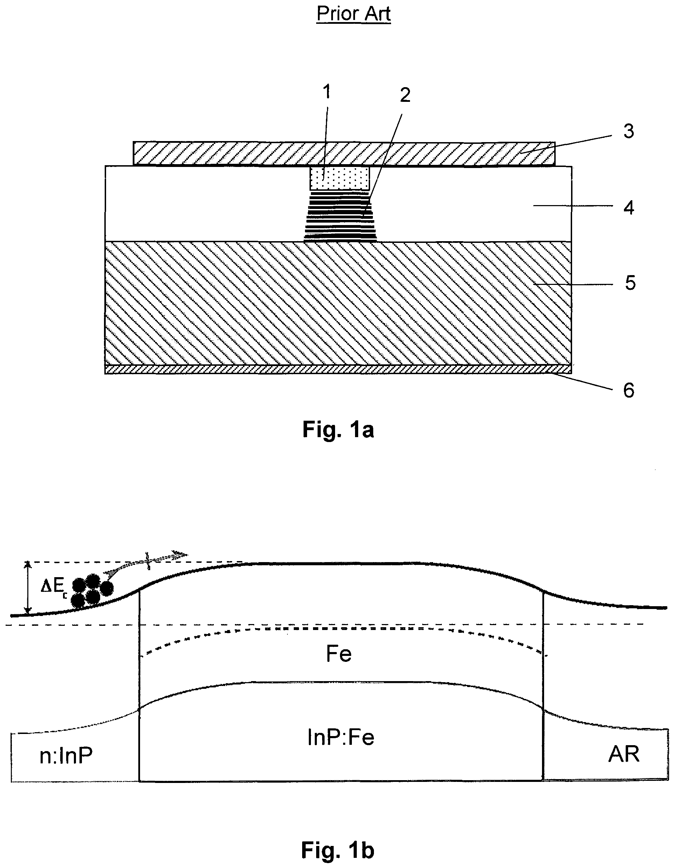

Figs. 1a and 1b, show schematically a prior art buried heterostructure quantum cascade laser, BH QCL, and the schematic band structure of an n:InP-InP:FeAR junction used in this prior art structure. AR stands for active region as usual.

In typical prior art structures, a substrate 5, usually InP, with a rear or back electrode 6, usually of Au, carries on its top an active region (AR) 2, usually InGaAs/AlInAs, laterally confined by blocking or burying layers 4, i.e. Fe-doped InP or of Fe-doped InGaAs. A top electrode 3, usually also of Au, and an n-doped cladding 1, usually composed of InP and/or a ternary such as InAIAs or InGaAs, complete the structure.

Since the n-doped cladding 1 is a conductor, it has a leakage current into the lateral confining/blocking layers 4. This major problem with buried heterostructure devices is usually solved by using Fe impurities in the InP blocking layers as mentioned above.

The schematic band structure of the n:InP-InP:Fe-AR junction in this a prior-art design is shown in Fig. 1b. As mentioned, the number of charge carriers moving from the n-doped InP cladding 1 into the InP blocking layer 4 is reduced by introducing Fe doping in the latter. The thus formed n:InP-InP:Fe junction blocks the carrier leakage from the n:doped InP cladding 1 to the InP:Fe blocking layer(s) 4. Thus the current is confined and the plurality of carriers are injected into the active region (AR) 2.

In fact, the Fe creates deep donor states in InP, pinning the Fermi level in the middle of the semiconductor forbidden gap. The built-in potential at the interface between the n-doped cladding and the Fe-doped blocking layer(s) acts as a barrier to block the electrons. Unfortunately this built-in potential depends on the maximum Fe-doping that can be incorporated in the InP and thus cannot be increased arbitrarily. The maximum Fe that can be incorporated by epitaxial growth is strongly influenced by the growth temperature. Increasing the growth temperature results in higher Fe-doping levels due to the improved cracking of the Fe precursor molecules.

Unfortunately the growth of QCLs can be performed at temperatures sensibly lower than the ones necessary to obtain high Fe dopings. Thus, especially for highly strained structures, the temperature for growing the burying layers cannot be increased arbitrarily without degrading the quality of the active layers. Therefore the Fe doping is generally limited to values between 2 and 8x10e16 cm⁻³, resulting in a blocking field between 50 and 100 kV/cm. This suffices to block electrons in QCLs emitting in the longer wavelength regions of the mid-IR range with operating fields generally smaller than 100kV/cm. However this is insufficient for short wavelength QCLs, in particular for lasers emitting in the 3-5µm range, where the operating field can exceed 100 kV/cm, resulting in a leakage current flowing through the burying layers.

Further, the growth of Fe-doped layers is strongly influenced by the so-called "background doping" of the machine used for the growth. This background doping is the number of carriers unintentionally added during the growth. InP e.g. is known to have the tendency to be slightly n-doped if grown "undoped". The amount of background doping depends on the equipment wherein the growth is performed, i.e. the growth chamber conditions. Additional precautions have to be taken to prevent any leakage path being introduced at the beginning of the epitaxial regrowth. This is e.g. described by O. Ostinelli et al. in "Growth and characterization of iron-doped semi-insulating InP buffer layers for Al-free GaInP/GaInAs high electron mobility transistors", published in the Journal of Applied Physics, vol. 108, no. 11, p. 114502, 2010.

To circumvent the problems mentioned above, the present invention introduces additional quantum barriers, constituted by AlInAs/AlAs, InGaAs, InGaAsP, or InGaSb, for example, that improve the blocking of electrons. These barriers block the carrier transport independently from their doping and therefore can be introduced without increasing the optical losses.

By modifying number and thickness of such quantum barriers, the conductivity inside the burying layer can be adjusted and/or reduced which makes such a QCL suitable for applied high electric fields.

A significant advantage is that the growth of such quantum barriers is completely independent of the doping and thus far less sensible to the growth conditions. As mentioned above, Fe-doping inside the burying layers is well known for introducing losses in the 3-5µm spectral region due to the presence of the absorption lines of the levels Fe3+ and Fe2+. This prevents the fabrication of high performance lasers in an interesting spectroscopic window, i.e. for wavelengths that are of interest for many medical and sensing applications due to the presence of fundamental resonances of C-H, O-H and N-H bonds.

With the present invention, a novel technique to block the electrons in the burying layers is created. In particular, the number of "blocking" quantum barriers can be adjusted according to the operating field of the laser and independent of any Fe-doping.

Furthermore, the use of quantum barriers according to the invention is fully compatible with the use of Fe-doping to further reduce the conductance in the regions where this will not introduce additional optical losses in the laser.

To summarize, the present invention introduces a novel method for producing buried heterostructure quantum cascade lasers, which method is not limited by growth conditions, especially growth temperature, and which method can generate optical waveguides with low losses in the desired mid-IR spectral range.

The following description of several embodiments names certain materials, e.g. InP, both intrinsic (i:InP) and doped, especially Fe-doped (InP:Fe), and InAIAs, to be used when executing this invention. It should be clear that other materials as InGaAs, AlAs, InAs, InGaAsP, InAIGaAs and the like can replace those mentioned without departing from the scope of this invention, as defined by claim 1.

Three embodiments of the present invention are described in the following.

### Embodiment A

This embodiment is a buried-heterostructure QCL emitting at 3.3µm.

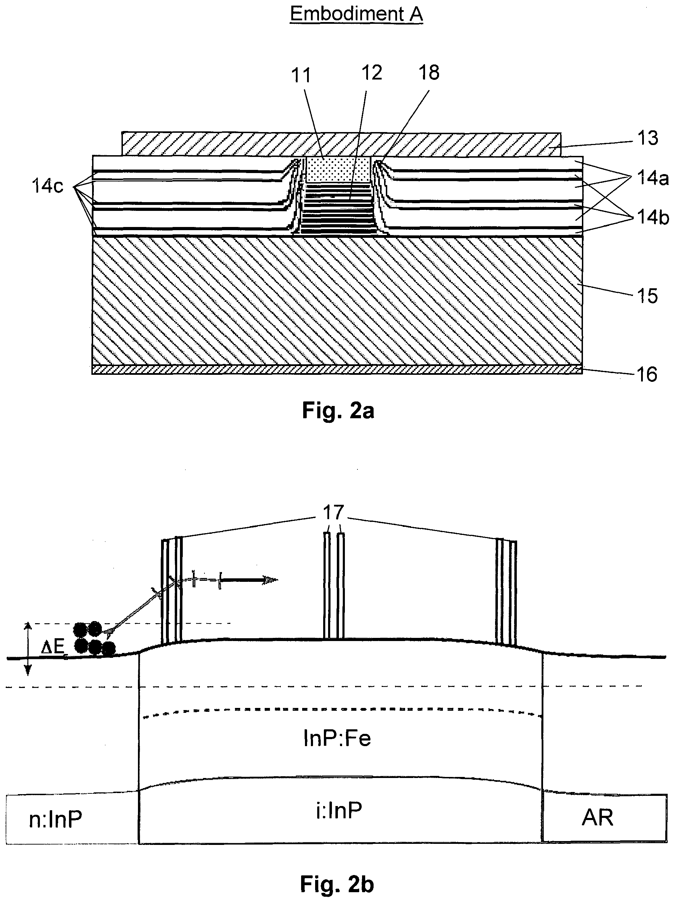

Fig. 2a shows this QCL with a layered arrangement, consisting of a couple of barriers confining the buried heterostructure. The structure consists of six quantum barriers of InAIAs embedded in layers of intrinsically undoped InP. This heterostructure provides the low loss waveguide and electron blocking sequence according to the invention. Its details are described in the following. A substrate 15, here InP, with a rear or back electrode 16, usually of Au, carries on its top an active region 12 of InGaAs/InAlAs, laterally confined by a heterostructure 14a/14b/14c. This heterostructure comprises three groups of different layers. Each layer 14a consist of intrinsic or undoped i:InP and each layer 14b consist of a semiconductor, here i:InP or InGaAs. The third group are the barrier layers 14c of AlInAs; they are shown in Fig. 2a as thin layers in solid black. Also shown in Fig. 2a are a top electrode 13, usually of Au, and an n-doped cladding 11 of InP and a ternary such as InAIAs or InGaAs. The sloped ends 18 of the barriers 14a-c are due to the epitaxial regrowth process taking place around the etched regions. They depend on the growth direction which is typically perpendicular to the etched surface.

Here are some approximate dimensions of the structure shown in Fig. 2a. The active region AR 12 is about 3µm thick and 3-20µm wide. The barrier heterostructure is about 6µm thick, as is the active region AR 12 plus the cladding 11, which usually is a few µm, here 3µm, thick.

The heterostructure of barrier layers is described in detail further down. The substrate 25 has a thickness of about 0.1-0.5mm. The whole structure shown in Fig. 2a is about 2mm long and 0.5mm wide. Please note that these are just approximate dimensions; they vary depending on the preferred wavelength and/or the intended use of the device. Also, Fig. 2a, as all figures, are not to scale.

Fig. 2b displays a schematic band structure of the quantum barrier sequence of the QCL shown in Fig. 2a. Please note that "i:InP" or "i-InP" stands for intrinsic InP, i.e. undoped InP. The barrier layers 14c function as quantum barriers 17, whose positions can change as well as the number - six such barriers 14c are shown in Fig. 2a - reduce the electron transport without increasing the optical losses. It is important to understand that in embodiment A, by using the shown barriers, carrier leakage can be prevented even without using the InP:Fe.

The table below discloses the physical structure including the thicknesses of the quantum barriers 14a-c. By introducing these quantum barriers, the electrical conductivity of the heterostructure 14a/14b/14c is reduced without increasing the optical losses, as mentioned above.

The difference between the prior art burying or blocking layers as shown in

Fig. 1a and the blocking layers according to the invention as depicted in Fig. 2a is obvious: whereas the prior art blocking layers consist throughout of Fe-doped InP, i.e. InP:Fe, the novel blocking layers according to the invention include a plurality of different layers including intrinsic/undoped InP.

The following table shows the dimensions of the confining layered heterostructure depicted in Fig. 2a with the quantum barriers 14a-c according to this embodiment A. Looking at the table below and at Fig. 2a, please note that "Start" defines the bottom of the heterostructure because this is where the regrowth is started. This means that the sequence shown in the table is reversed in the stack shown in Fig. 2a. Further, layers 14b may consist of intrinsic InP, i.e. i:InP as shown in the table, or InAIAs, as explained above. Thus, layers 14a and 14b may consist of different materials. Finally, as mentioned above, Fig. 2a is not true to scale, i.e. the sample dimensions and relations given in the table are not reflected in the figure. Please note that the barrier layers are shown in bold letters.

**Embodiment A**

| Top | |
|---|---|
| *i:InP* - 14a | 100 nm |
| **InAIAs - 14c** | **50 nm** |
| *i:InP or InGaAS* - 14b | 100 nm |
| **InAIAs - 14c** | **50 nm** |
| *i:InP* - 14a | 600 nm |
| **InAIAs - 14c** | **50 nm** |
| *i:InP or InGaAs* - 14b | 100 nm |
| **InAIAs** - **14c** | **50 nm** |
| *i:InP* - 14a | 600nm |
| **InAIAs - 14c** | **50 nm** |
| *i:InP or InGaAs* - 14b | 100 nm |
| **InAIAs - 14c** | **50 nm** |

### Embodiment B

Embodiment B is another buried-heterostructure QCL emitting at 3.3µm. Its overall dimensions are similar to the dimensions of Embodiment A.

However, to furthermore decrease the electrical conductivity for a given number of quantum barriers, Fe doping of the InP regions is partially reintroduced, but only far from the active region. In this case, Fe doping is only present close to the junction with the n-doped contact where the electrons are injected and not near the active region AR where the optical mode is relevant.

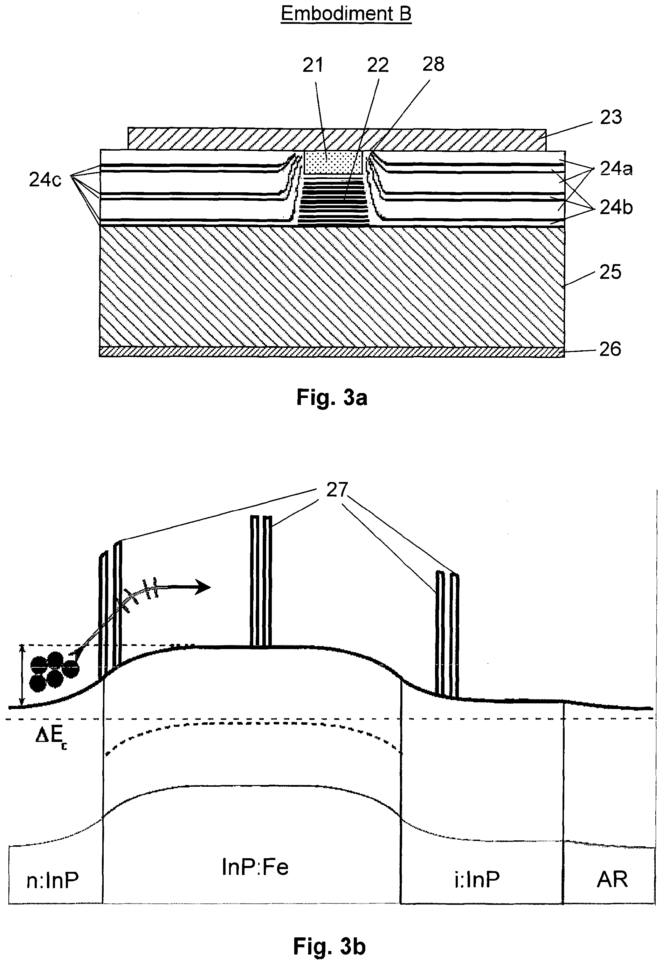

Fig. 3a shows this second embodiment according to the invention. The structure includes a substrate 25, here InP, with a rear or back electrode 26, usually of Au, a top electrode 23, usually also of Au, and a n-doped cladding 21, composed of InP and/or a ternary such as InAIAs or InGaAs on top of its active region 22 of InGaAs/InAlAs.

As in Embodiment A, the active region 22 is laterally confined on both sides by a barrier heterostructure with three groups of layers 24a/24b/24c of which the six layers 24c serve as blocking layers, consisting of InAIAs. As in Embodiment A, six quantum barriers 24c of InAIAs are used for electron blocking; further, the sloped ends 28 of the layers 24c are due to the epitaxial regrowth process taking place around the etched regions.

This Embodiment B differs from Embodiment A in that the five InP layers 24a and 24b closest to the electric contact 23 are doped with Fe, InP:Fe. Another difference to Embodiment A is a two-component burying layer 24a consisting of a deposit of Fe-doped InP, InP:Fe, and a deposit of intrinsic InP, i:InP, each of 300nm thickness in the example shown.

Alternatively, all layers 24a and 24b in Embodiment B may be Fe-doped, i.e. consist of InP:Fe, whereby the Fe-doping level is reduced in the proximity of the active region 22.

Layers 24b may also consist of InGaAs instead of InP as in Embodiment A, Fig. 2a. Such InGaAs layers would be Fe-doped as explained above in connection with the respective InP layers. As mentioned, quantum barriers 24c confining or separating the burying layers 24a and 24b, consist of undoped InAIAs, again as in Embodiment A. So the difference to Embodiment A lies in the described Fe-doping of the layers 24a and b and the provision of at least one two-component burying layer 24a as mentioned above.

Fig. 3b displays a schematic band structure of the quantum barrier sequence of the QCL shown in Fig. 3a. In this case both the quantum barriers 24c and the Fe-doped layers 24a and 24b serve to block the carriers. The table below shows sample dimensions of a structure according to Fig. 3a:

**Embodiment B**

| Top | |
|---|---|
| *InP:Fe* - 24a | 100 nm |
| **InAIAs - 24c** | **50 nm** |
| *InP:Fe* - 24b | 100 nm |
| **InAIAs - 24c** | **50 nm** |
| *InP:Fe* - 24a | 300 nm |
| *i:InP-* 24a | 300 nm |
| **InAIAs - 24c** | **50 nm** |
| *InP:Fe* - 24b | 100 nm |
| **InAIAs - 24c** | **50 nm** |
| *i:InP* - 24a | 600 nm |
| **InAIAs - 24c** | **50 nm** |
| *i:InP* - 24b | 100 nm |
| **InAIAs - 24c** | **50 nm** |

### Embodiment C

This embodiment is a third buried-heterostructure QCL, a structure emitting at a wavelength of 4.3µm with a high operating field to reduce electron leakage.

The basic structure of this embodiment is identical to the structure of Embodiment A, i.e. the confining layered barrier heterostructure comprises three groups of layers, a barrier group consisting of InAIAs, a second group of InP and a third group of either InP or InGaAs layers. The difference to the two aforementioned embodiments is that all InP or InGaAs layers are Fe-doped. Thus both the quantum barriers and the Fe doping serve to block the carriers which can be important and crucial for QCLs operating in a high electric field.

The following table shows structure and dimensions of this third embodiment:

**Embodiment C**

| Top | |
|---|---|
| *InP:Fe* | 100 nm |
| **InAlAs** | **50 nm** |
| *InP:Fe* | 100 nm |
| **InAlAs** | **50 nm** |
| *InP:Fe* | 600 nm |
| **InAlAs** | **50 nm** |
| *InP:Fe* | 100 nm |
| **InAlAs** | **50 nm** |
| *InP:Fe* | 600 nm |
| **InAlAs** | **50 nm** |
| *InP:Fe* | 100 nm |
| **InAlAs** | **50 nm** |

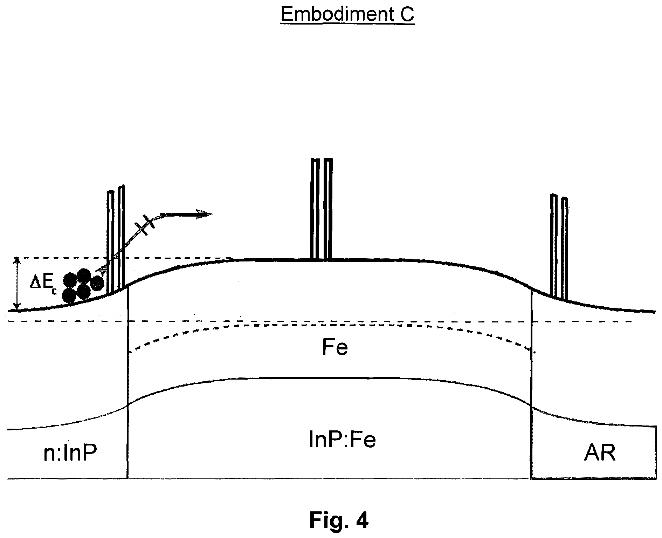

Fig. 4 shows the schematic band structure of this third QCL embodiment according to the invention. Alternatively to the structure according to the table above, eight quantum barriers may be used for electron blocking in this case. The above detailed description of the function and of various embodiments of the present invention permit a person skilled in the art to devise further implementations without departing from the scope of this invention, as defined by claim 1.

## Claims

1. A semiconductor quantum cascade laser, emitting especially at wavelengths in the mid-IR range, with a substrate (15; 25), an active region (12; 22), a cladding (11; 21), and at least two electrodes (13, 16; 23, 26) providing for current injection into said active region (12; 22), said active region and said cladding being laterally confined by a current-blocking layer (14a, 14b, 14c, 24a, 24b) so as to form a buried-heterostructure waveguide, ***characterized by*** said current-blocking layer including a stack of a plurality of barrier layers (14c; 24c) of a first III-V semiconductor compound staggered alternatingly with a plurality of burying layers (14a, 14b; 24a, 24b) of at least one second III-V semiconductor compound.

2. The quantum cascade laser according to claim 1, *wherein* at least one of the barrier layers (14c; 24c) consists of a compound of one of the group of AlAs, InAIAs, InGaAs, InGaAsP, or InGaSb.

3. The quantum cascade laser according to any of the preceding claims, *wherein* at least one of the burying layers (14a; 24a) comprises a first III-V semiconductor compound and at least another one of the burying layers (14b; 24b) comprises a second, different III-V semiconductor compound.

4. The quantum cascade laser according to claim 3, *wherein* the first semiconductor compound of the burying layers (14a, 14b; 24a, 24b) is an intrinsic compound, in particular i:InP, whereas the second compound is a doped compound, in particular an Fe-doped compound, especially Fe-doped InP.

5. The quantum cascade laser according to claim 3, *wherein* at least one of the burying layers (24a) comprises both an intrinsic compound, in particular i:InP, and a second, doped compound, in particular an Fe-doped compound, especially Fe-doped InP.

6. The quantum cascade laser according to claim 3, *wherein* both the first semiconductor compound of said burying layers (14a, 14b; 24a, 24b) and the second compound are doped compounds, in particular an Fe-doped compound, especially Fe-doped InP.

7. The quantum cascade laser according to any of the preceding claims, said current-blocking layer comprising a first number of, prefereably six, barrier layers (14c; 24c) and a second number of, prefereably six, burying layers (14a, 14b; 24a, 24b), said barrier layers being alternately stacked with said burying layers.

8. The quantum cascade laser according to claim 7, *wherein* each barrier layer (14c; 24c) is between 5 and 200nm, preferably about 50nm thick, whereas the burying layers are between about 50nm and about 3µm, preferably 600nm thick.

9. The quantum cascade laser according to any of the preceding claims, said current-blocking layer being of the following structure:
| Top Electrode (13) | |
|---|---|
| i:InP (14a) | 100 nm |
| InAIAs (14c) | 50 nm |
| i:InP or InGaAS (14b) | 100 nm |
| InAlAs (14c) | 50 nm |
| i:InP (14a) | 600 nm |
| InAlAs (14c) | 50 nm |
| i:InP or InGaAS (14b) | 100 nm |
| InAlAs (14c) | 50 nm |
| i:InP (14a) | 600nm |
| InAlAs (14c) | 50 nm |
| i:InP or InGaAS (14b) | 100 nm |
| InAlAs (14c) | 50 nm |

10. The quantum cascade laser according to any of the claims 1 to 8 said current-blocking layer being of the following structure:
| Top Elektrode (23) | |
|---|---|
| InP:Fe (24a) | 100 nm |
| InAlAs (24c) | 50 nm |
| InP:Fe (24b) | 100 nm |
| InAlAs (24c) | 50 nm |
| InP:Fe (24a) | 300 nm |
| i:InP (24a) | 300 nm |
| InAlAs (24c) | 50 nm |
| InP:Fe (24b) | 100 nm |
| InAlAs (24c) | 50 nm |
| i:InP (24a) | 600 nm |
| InAlAs (24c) | 50 nm |
| i:InP (24b) | 100 nm |
| InAlAs (24c) | 50 nm |

11. The quantum cascade laser according to any of the claims 1 to 8, said current-blocking layer being of the following structure:
| Top | |
|---|---|
| InP:Fe | 100 nm |
| InAlAs | 50 nm |
| InP:Fe | 100 nm |
| InAlAs | 50 nm |
| InP:Fe | 300 nm |
| InAlAs | 50 nm |
| InP:Fe | 100 nm |
| InAlAs | 50 nm |
| InP:Fe | 600 nm |
| InAlAs | 50 nm |
| InP:Fe | 100 nm |
| InAlAs | 50 nm |

## Patentansprüche

1. Halbleiter-Quantenkaskadenlaser, der insbesondere bei Wellenlängen im mittleren IR-Bereich emittiert, mit einem Substrat (15; 25), einem aktiven Bereich (12; 22), einer Ummantelung (11; 21) und mindestens zwei Elektroden (13, 16; 23, 26), die für Stromeinspeisung in den aktiven Bereich (12, 22) sorgen, wobei der aktive Bereich und die Ummantelung seitlich von einer Stromsperrschicht (14a, 14b, 14c, 24a, 24b) begrenzt sind, um einen verdeckten Heterostruktur-Wellenleiter zu bilden,
***dadurch gekennzeichnet,***
**dass** die Stromsperrschicht einen Stapel aus einer Mehrzahl Sperrschichten (14c; 24c) einer ersten III-V-Halbleiterverbindung enthält, die abwechselnd mit einer Mehrzahl Deckschichten (14a, 14b; 24a, 24b) mindestens einer zweiten III-V-Halbleiterverbindung gestaffelt sind.

2. Quantenkaskadenlaser nach Anspruch 1, *wobei*
mindestens eine der Sperrschichten (14c; 24c) aus einer Verbindung der Gruppe aus AlAs, InAIAs, InGaAs, InGaAsP oder InGaSb besteht.

3. Quantenkaskadenlaser nach einem der vorhergehenden Ansprüche, *wobei*
mindestens eine der Deckschichten (14a; 24a) eine erste III-V-Halbleiterverbindung aufweist und mindestens eine andere der Deckschichten (14b; 24b) eine zweite, verschiedene III-V-Halbleiterverbindung aufweist.

4. Quantenkaskadenlaser nach Anspruch 3, *wobei*
es sich bei der ersten Halbleiterverbindung der Deckschichten (14a, 14b; 24a, 24b) um eine reine Verbindung handelt, insbesondere um i:InP, wobei es sich bei der zweiten Verbindung um eine dotierte Verbindung handelt, insbesondere um eine Fe-dotierte Verbindung, speziell um Fe-dotiertes InP.

5. Quantenkaskadenlaser nach Anspruch 3, *wobei*
mindestens eine der Deckschichten (24a) sowohl eine reine Verbindung, insbesondere i:InP, als auch eine zweite, dotierte Verbindung aufweist, insbesondere eine Fe-dotierte Verbindung, speziell Fe-dotiertes InP.

6. Quantenkaskadenlaser nach Anspruch 3, *wobei*
es sich sowohl bei der ersten Halbleiterverbindung der Deckschichten (14a, 14b; 24a, 24b) als auch bei der zweiten Verbindung um dotierte Verbindungen handelt, insbesondere um eine Fe-dotierte Verbindung, speziell um Fe-dotiertes InP.

7. Quantenkaskadenlaser nach einem der vorhergehenden Ansprüche, wobei die Stromsperrschicht eine erste Anzahl von vorzugsweise sechs Sperrschichten (14c; 24c) und eine zweite Anzahl von vorzugsweise sechs Deckschichten (14a, 14b; 24a, 24b) aufweist, wobei die Sperrschichten abwechselnd mit den Deckschichten gestaffelt sind.

8. Quantenkaskadenlaser nach Anspruch 7, *wobei*
jede Sperrschicht (14c; 24c) zwischen 5 und 200 nm, vorzugsweise ungefähr 50 nm dick ist, wobei die Deckschichten zwischen ungefähr 50 nm und ungefähr 3 µm, vorzugsweise 600 nm dick sind.

9. Quantenkaskadenlaser nach einem der vorhergehenden Ansprüche, *wobei* die Stromsperrschicht die folgende Struktur aufweist:

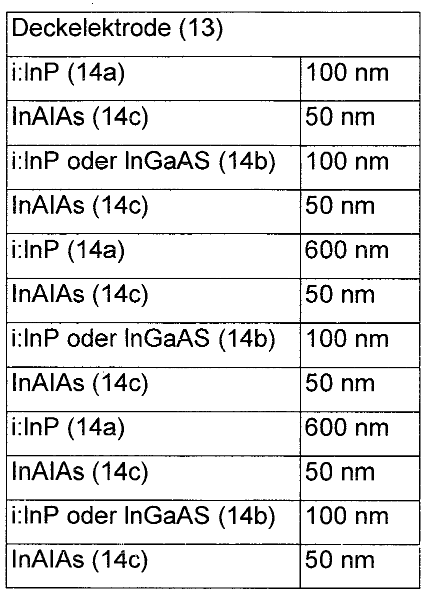

10. Quantenkaskadenlaser nach einem der Ansprüche 1 bis 8, wobei die Stromsperrschicht von folgender Struktur ist:

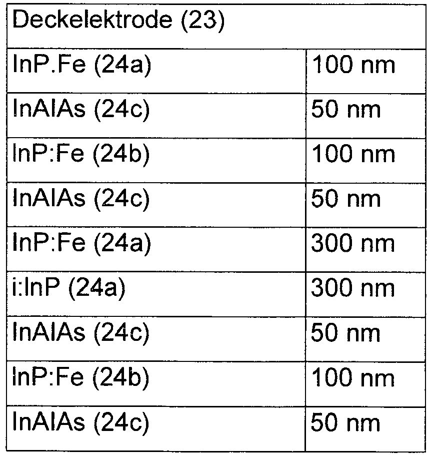

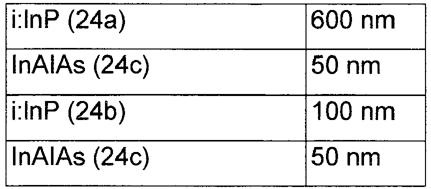

11. Quantenkaskadenlaser nach einem der Ansprüche 1 bis 8, wobei die Stromsperrschicht von folgender Struktur ist:

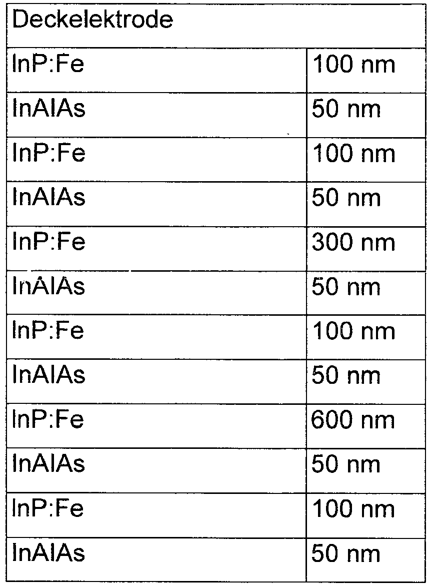

## Revendications

1. Laser à cascade quantique à semiconducteurs, émettant tout particulièrement à des longueurs d'onde dans la plage de l'infrarouge moyen, avec un substrat (15 ; 25), une région active (12 ; 22), un gainage (11 ; 21) et au moins deux électrodes (13, 16 ; 23, 26) qui sont prévues pour une injection de courant à l'intérieur de ladite région active (12 ; 22), ladite région active et ledit gainage étant confinés latéralement par une couche de blocage de courant (14a, 14b, 14c, 24a, 24b) de manière à former un guide d'ondes à hétérostructure enfouie ;
**caractérisé en ce que** :
ladite couche de blocage de courant inclut une pile constituée par une pluralité de couches de barrière (14c ; 24c) en un premier composé semiconducteur III-V qui sont disposées en alternance avec une pluralité de couches d'enfouissement (14a, 14b; 24a, 24b) en au moins un second composé semiconducteur III-V.

2. Laser à cascade quantique selon la revendication 1, dans lequel au moins l'une des couches de barrière (14c ; 24c) est constituée par un composé qui est l'un du groupe de composés qui comprend AlAs, InAlAs, InGaAs, InGaAsP et InGaSb.

3. Laser à cascade quantique selon l'une quelconque des revendications précédentes, dans lequel au moins l'une des couches d'enfouissement (14a ; 24a) comprend un premier composé semiconducteur III-V et au moins une autre des couches d'enfouissement (14b ; 24b) comprend un second composé semiconducteur III-V différent.

4. Laser à cascade quantique selon la revendication 3, dans lequel le premier composé semiconducteur des couches d'enfouissement (14a, 14b ; 24a, 24b) est un composé intrinsèque, en particulier i:InP, tandis que le second composé est un composé dopé, en particulier un composé dopé au Fe, tout particulièrement de l'InP dopé au Fe.

5. Laser à cascade quantique selon la revendication 3, dans lequel au moins l'une des couches d'enfouissement (24a) comprend à la fois un composé intrinsèque, en particulier i:InP, et un second composé dopé, en particulier un composé dopé au Fe, tout particulièrement de l'InP dopé au Fe.

6. Laser à cascade quantique selon la revendication 3, dans lequel le premier composé semiconducteur desdites couches d'enfouissement (14a, 14b ; 24a, 24b) et le second composé sont tous deux des composés dopés, en particulier un composé dopé au Fe, tout particulièrement de l'InP dopé au Fe.

7. Laser à cascade quantique selon l'une quelconque des revendications précédentes, ladite couche de blocage de courant comprenant un premier nombre, de préférence six, de couches de barrière (14c ; 24c) et un second nombre, de préférence six, de couches d'enfouissement (14a, 14b; 24a, 24b), lesdites couches de barrière étant empilées en alternance avec lesdites couches d'enfouissement.

8. Laser à cascade quantique selon la revendication 7, dans lequel chaque couche de barrière (14c; 24c) présente une épaisseur qui est comprise entre 5 nm et 200 nm, de préférence d'environ 50 nm, tandis que les couches d'enfouissement présentent une épaisseur qui est comprise entre environ 50 nm et environ 3 µm, de préférence 600 nm.

9. Laser à cascade quantique selon l'une quelconque des revendications précédentes, ladite couche de blocage de courant étant de la structure qui suit:

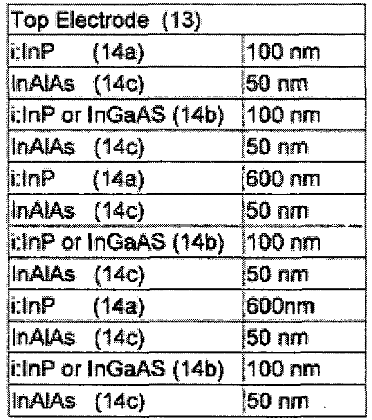

10. Laser à cascade quantique selon l'une quelconque des revendications 1 à 8, ladite couche de blocage de courant étant de la structure qui suit :

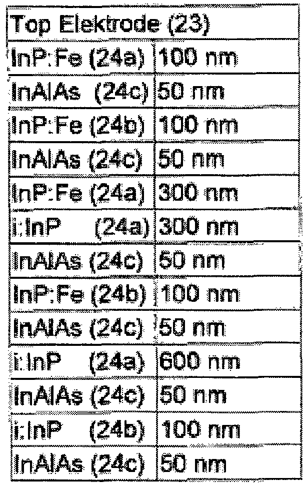

11. Laser à cascade quantique selon l'une quelconque des revendications 1 à 8, ladite couche de blocage de courant étant de la structure qui suit :
